# EUROPEAN PATENT APPLICATION

(11) **EP 4 783 154 A1**
(43) Date of publication of application: **29.07.2026**
(21) Application number: 23958394.1
(22) Date of filing: 09.11.2023
(51) Int. Cl.: G09G 5/10

(54) **DISPLAY DEVICE FOR SIGNAGE AND DRIVING METHOD THEREOF**

(71) Applicant: LG Electronics Inc., Yeongdeungpo-gu Seoul 07336 (KR)
(72) Inventor: BANG, Jooeun, Seoul 06772 (KR); SHIM, Minhee, Seoul 06772 (KR); SON, Kihoon, Seoul 06772 (KR)
(74) Representative: Schott, Jakob Valentin
(86) International application number: PCT/KR2023/017937
(87) International publication number: WO 2025/100595

(57) **Abstract**

A display device for signage according to an embodiment of the present invention includes an LED package having a plurality of LED groups, an illuminance sensor for detecting illuminance of external light, and a controller for controlling the LED package according to the illuminance sensor, wherein the plurality of LED groups have different forward voltages from each other, and the controller may drive the LED package in different modes according to the illuminance sensor.

## Description

### Technical Field

The present invention relates to a display device for signage and a driving method thereof.

### Background Art

Digital Signage is a display installed inside or outside a building using a Digital Information Display (DID), and is a device that provides an image or a video including advertisement or various information.

Types of digital signage include outdoor digital signage and indoor digital signage.

Outdoor digital signage refers to digital signage installed on an outer wall of a building, an electric signboard, or installed outdoors for an outdoor cinema. Indoor digital signage refers to digital signage installed on an inner wall of a large shopping mall or installed in a form of a standing signboard.

When digital signage is used in an outdoor environment, high luminance light is required to improve visibility during daytime when sunlight is strong.

However, when digital signage is used at night, high luminance light is not required, and in various countries or regions, a maximum luminance value used at night is limited.

Generally, a range of the maximum luminance value available at night is 100 to 300 nits, and when luminance is limited accordingly, since current is fixed in a conventional driver IC, a low bit color depth has to be used to lower luminance, thereby causing a problem in image quality in a low grayscale (0 to 36 gray).

In order to solve such a problem, internally developed technology has developed an LED package to which a low grayscale compensation function is additionally applied, however, there has been a problem in that side effects such as a non-lighting phenomenon and a flicker phenomenon occur due to application of the low grayscale compensation technology.

### Mode for Invention

### Technical Problem

The present invention is to provide a display device for signage and a driving method thereof in which color depth in a low grayscale is improved even at night when luminance is limited.

The present invention is to provide a display device for signage and a driving method thereof for preventing a color lumping phenomenon in a low grayscale.

The present invention is to provide a display device for signage and a driving method thereof for preventing a non-lighting phenomenon in a low grayscale.

The present invention is to provide a display device for signage and a driving method thereof for preventing a flicker phenomenon in a low grayscale.

### Technical Solution

A display device for signage according to an embodiment of the present invention includes: an LED package having a plurality of LED groups; an illuminance sensor for detecting illuminance of external light; and a controller for controlling the LED package according to the illuminance sensor; wherein the plurality of LED groups have different forward voltages from each other, and the controller may drive the LED package in different modes according to the illuminance sensor.

The LED package includes a first LED group including a first Red chip, a first Green chip, and a first Blue chip, and a second LED group including a second Red chip, a second Green chip, and a second Blue chip, and a forward voltage of the second LED group may be smaller than a forward voltage of the first LED group.

The controller drives the LED package in a daytime mode when it is determined that an external environment is daytime by the illuminance sensor, and in the daytime mode, the LED package may drive the first LED group and may not drive the second LED group.

The controller drives the LED package in an HDR mode when it is determined that the external environment requires high luminance light by the illuminance sensor, and in the HDR mode, the LED package may drive both the first LED group and the second LED group.

The controller drives the LED package in a night mode when it is determined that the external environment is night by the illuminance sensor, and in the night mode, the LED package may not drive the first LED group and may drive only the second LED group.

In a method of driving a display device for signage, the controller controls the LED package in a daytime mode, an HDR mode, and a night mode according to the illuminance sensor, and the LED package may have a different amount of applied current depending on the mode.

When the controller drives the LED package in the night mode, a current applied to the LED package may be smaller than a current applied to the LED package in the daytime mode and the HDR mode.

### Advantageous Effects

A display device for signage (1000) according to an embodiment may include a first LED group (100) and a second LED group (200).

At this time, in the night mode of the display device for signage (1000) according to the embodiment, the LED package may be limited to a predetermined light amount, for example, a luminance of 300 nit. For example, in the night mode of the display device for signage (1000) according to the embodiment, the LED package (10P) may drive only the second LED group (200).

Since the second LED group (200) consumes a small driving current, it may have a color depth of 14 bit even in a low grayscale. Accordingly, a non-lighting phenomenon and a color lumping phenomenon in a low grayscale can be prevented.

In the embodiment, the second LED group (200) may function as an offset of the first LED group (100). That is, the LED package may be turned on by the second LED group (200).

Since the second LED group (200) has a forward voltage lower than the forward voltage of the first LED group (100), unlike a conventional offset, an influence on image quality may be small.

Further, since the first LED group (100) and the second LED group (200) have different forward voltages (Vf), that is, different amplitudes, lighting in a low grayscale is possible using only the second LED group (200). Accordingly, a color lumping phenomenon in a low grayscale and a non-lighting phenomenon in a certain section of a low grayscale can be prevented.

In the embodiment, the controller (20) may control a mode of the display (1) according to an amount of light recognized by the illuminance sensor (30).

For example, a mode of the display device for signage (1000) may include a daytime mode, an HDR mode, and a night mode.

The controller (20) may control the display device for signage (1000) in the daytime mode when it is recognized that the external environment is daytime according to the amount of light recognized by the illuminance sensor (30). In the daytime mode of the display device for signage (1000), the LED package (10P) may drive only the first LED group (100), and may not drive the second LED group (200).

The controller (20) may control the LED package (10P) in the HDR mode when the external environment is a time or a season in which sunlight is strong according to the amount of light recognized by the illuminance sensor (30). In the HDR mode of the display device for signage (1000), the LED package (10P) may drive both the first LED group (100) and the second LED group (200).

The controller (20) may control the display device for signage (1000) in the night mode when it is recognized that the external environment is night according to the amount of light recognized by the illuminance sensor (30). In the night mode of the display device for signage (1000), the LED package (10P) may drive only the second LED group (200), and may not drive the first LED group (100).

Since a current range of the second LED group (200) is formed to be small, a low grayscale having high color depth can be expressed even at a low luminance of 300 nit or less.

Since the current range of the second LED group (200) is formed to be smaller than a current range of the first LED group (100), an effect of energy reduction can be obtained in the night mode.

Further, since LED groups driven according to each mode are different, a current applied to the LED package may be formed differently in each mode. Accordingly, in the night mode, a non-lighting phenomenon, a color lumping phenomenon, and a flicker phenomenon in a low grayscale can be prevented.

Further, as the display device for signage according to an embodiment of the present invention has an expressive power of 14 bit, a non-lighting phenomenon in a low grayscale section does not occur, and there is a technical effect in that a color lumping and a non-uniform problem of pixels do not occur.

### Description of Drawings

FIG. 1A is an exemplary view of a display device (1000) including a semiconductor light emitting element for a display pixel according to an embodiment.
FIG. 1B is a perspective view of one of a plurality of display modules (1200) included in the display device (1000) according to an embodiment.
FIG. 1C is a plan view of one display panel (1210) included in a display panel (1210) according to an embodiment.
FIG. 2 illustrates an LED package of a display device for signage according to an embodiment of the present invention.
FIG. 3 is a graph showing luminance and color depth of a display device for signage according to internally developed technology.
FIG. 4 is a graph showing luminance and grayscale level of an LED package in an HDR mode of a display device for signage according to an embodiment of the present invention.
FIG. 5 is a graph showing luminance and grayscale level of an LED package in a night mode of a display according to an embodiment of the present invention.
FIG. 6 illustrates a constant current waveform of a display device for signage according to internally developed prior technology.
FIG. 7 illustrates a frame-by-frame PWM of a display device for signage according to internally developed technology.
FIG. 8 is a graph showing side effects when an offset is applied to a display device for signage according to internally developed technology.
FIG. 9 illustrates a waveform of a display device for signage (1000) according to an embodiment of the present invention.
FIG. 10 illustrates a PWM graph of a display device for signage (1000) according to an embodiment of the present invention.
FIG. 11 is a diagram illustrating a configuration of a display device for signage according to an embodiment of the present invention.
FIG. 12 is a graph showing a gamma curve of a display device for signage according to internally developed prior technology and a gamma curve according to an embodiment of the present invention.
FIG. 13 is a photograph comparing expressive power of a display device for signage according to internally developed technology and a display device for signage according to an embodiment of the present invention.

### Mode for Invention

Hereinafter, embodiments that can specifically implement the above-described technical problem will be described with reference to the accompanying drawings.

In the description of the embodiment, when it is described that each component is formed "on or under," the "on or under" includes both a case where two components are in direct contact with each other and a case where one or more other components are disposed between the two components. In addition, when expressed as "on or under," it may include not only an upper direction but also a lower direction based on one component.

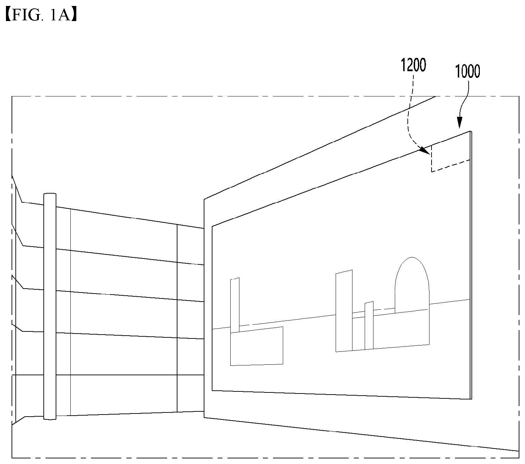

FIG. 1A is an exemplary view of a display device (1000) including a semiconductor light emitting element for a display pixel according to an embodiment. The display device (1000) according to the embodiment may include a plurality of assembled display modules (1200).

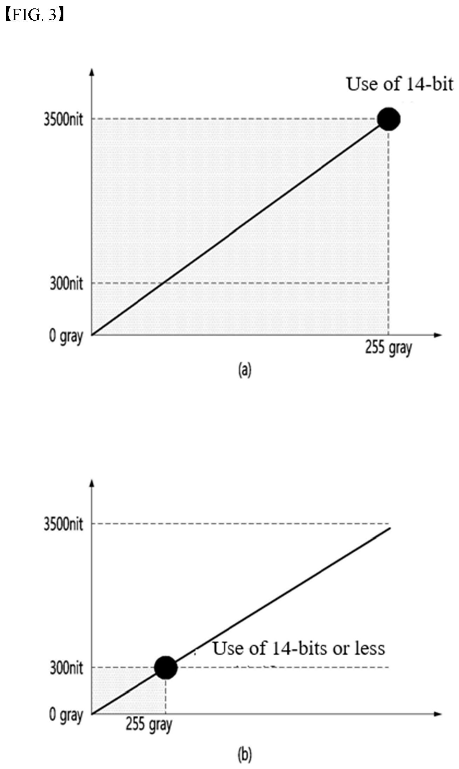

The display device (1000) of the embodiment can be applied to Digital Signage. For example, although FIG. 3A is an example of indoor digital signage, the display device (1000) of the embodiment can be applied to outdoor digital signage.

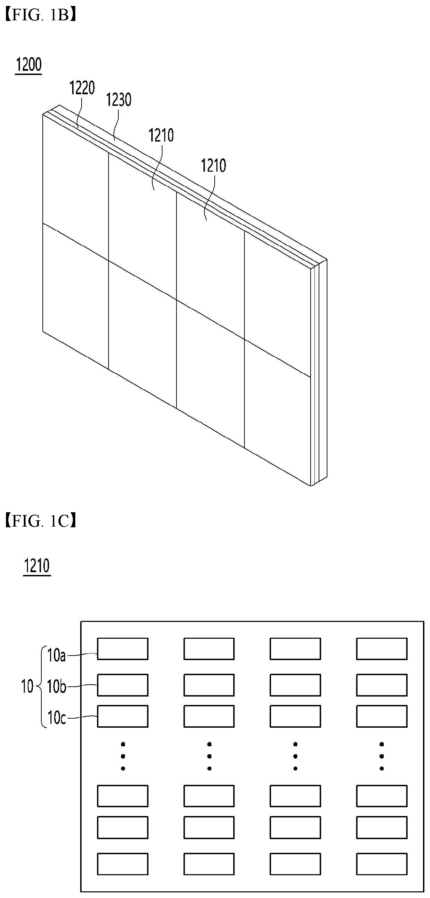

FIG. 1B is a perspective view of one of a plurality of display modules (1200) included in the display device (1000) according to an embodiment.

The display panel (1200) illustrated in FIG. 1B may be mounted in each cabinet and assembled in a block manner to implement the display device (1000) of the embodiment.

The display module (1200) of the embodiment may include a plurality of display panels (1210) that output an image, a module holder (1220) on which the display panels (1210) are disposed, and a module cover (1230) disposed outside the module holder (1220).

The plurality of display panels (1210) may be arranged on the module holder (1220) in a grid form to configure one display module (1200), and individual display modules (1200) may be assembled in a predetermined cabinet form to implement the display device (1000) according to the embodiment. Display data may be transmitted to the assembled individual display modules (1200) in a wired or wireless manner.

FIG. 1C is a plan view of one display panel (1210) included in a display panel (1210) according to an embodiment.

Referring to FIG. 1C, the display panel (1210) according to the embodiment may include a semiconductor light emitting element (10) for a display pixel that implements each pixel.

For example, the semiconductor light emitting element (10) for a display pixel according to the embodiment may include a first semiconductor light emitting element (10a), a second semiconductor light emitting element (10b), and a third semiconductor light emitting element (10c), but is not limited thereto.

Each of the first to third semiconductor light emitting elements (10a, 10b, 10c) may constitute individual subpixels and may be repeatedly arranged. For example, the first to third semiconductor light emitting elements (10a, 10b, 10c) may be a Red light emitting element, a Green light emitting element, and a Blue light emitting element, respectively, but are not limited thereto. For example, each of the first to third semiconductor light emitting elements may include all of a Red light emitting element, a Green light emitting element, and a Blue light emitting element.

Each of the first to third semiconductor light emitting elements (10a, 10b, 10c) may have a size in a micrometer (um) unit. The micrometer size may mean that a width of at least one surface of the light emitting element has a size of several to several hundred um.

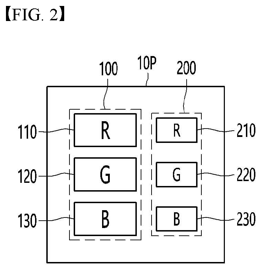

FIG. 2 illustrates an LED package (10P) of a display device for signage (1000) according to an embodiment of the present invention.

The LED package (10P) of the display device for signage according to the embodiment may include a first LED group (100) and a second LED group (200).

The first LED group (100) may include a first Red chip (110), a first Green chip (120), and a first Blue chip (130).

The second LED group (200) may include a second Red chip (210), a second Green chip (220), and a second Blue chip (230).

A current range of the second LED group (200) may be smaller than a current range of the first LED group (100).

A forward voltage (VF) of the first LED group (100) may be different from a forward voltage (VF) of the second LED group (200).

For example, the current range of the first LED group (100) may be 1 mA to 10 mA, and the current range of the second LED group (200) may be 0.1 mA to 1 mA.

FIG. 3 is a graph showing luminance and color depth of a display device for signage according to internally developed technology.

FIG. 3(a) is a graph showing a relationship between luminance and grayscale when a display device for signage according to internally developed technology is used in daytime.

FIG. 3(b) is a graph showing a relationship between luminance and grayscale when a display device for signage according to internally developed technology is used at night.

In FIGS. 3(a) and 3(b), an x-axis of the graph represents grayscale level, a y-axis represents luminance, and a slope represents current.

The LED package of the display device for signage according to internally developed technology may have one LED group.

In the display device for signage according to internally developed technology, an indoor driver IC is mainly used. In the case of such an indoor driver IC, current is fixed and a maximum current may be limited.

Accordingly, when the display device for signage according to internally developed technology is used at night where luminance is limited to 300 nit, there is a problem in that it is difficult to express all of a 14-bit color depth.

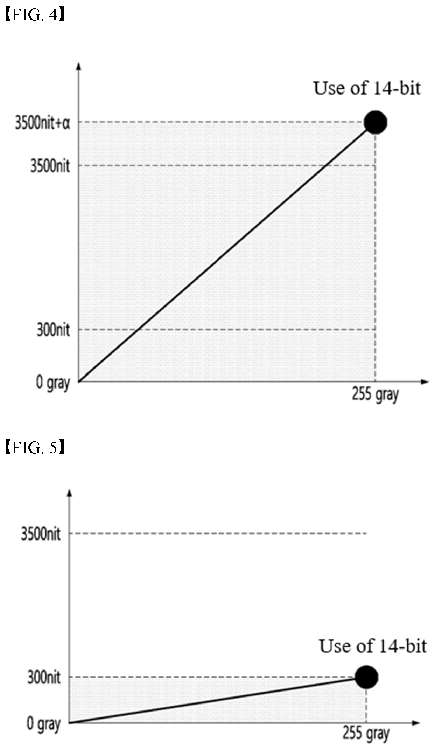

FIG. 4 is a graph showing luminance and grayscale level of an LED package in an HDR mode of a display device for signage according to an embodiment of the present invention.

The display device for signage according to an embodiment may be driven in a plurality of modes. For example, when luminance brighter than a conventional luminance is required at a time or a season in which sunlight is strong during daytime, the display device may be driven in an HDR mode.

When the display device for signage (1000) is driven in the HDR mode, the LED package (10P) may drive both the first LED group (100) and the second LED group (200).

That is, when driven in the HDR mode, the display for signage (1) may have a luminance of 3500 nit or more.

FIG. 5 is a graph showing luminance and grayscale level of an LED package in a night mode of a display according to an embodiment of the present invention.

In the night mode of the display device for signage (1000) according to an embodiment, the LED package may be limited to a luminance of 300 nit.

In the night mode of the display device for signage (1000) according to an embodiment, the LED package (10P) may drive only the second LED group (200).

Since the second LED group (200) consumes a small driving current, it may have a 14-bit color depth even in a low grayscale.

Accordingly, a non-lighting phenomenon and a color lumping phenomenon in a low grayscale can be prevented.

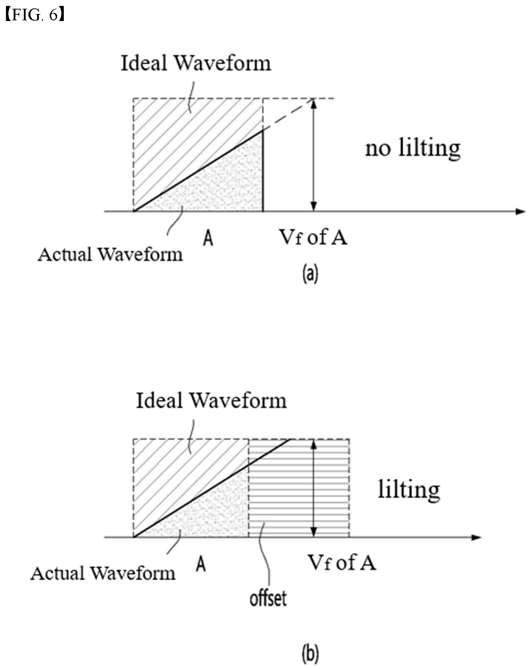

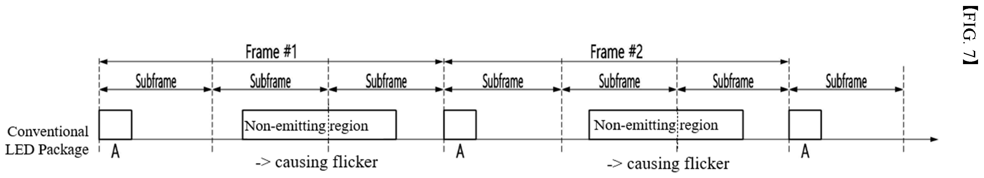

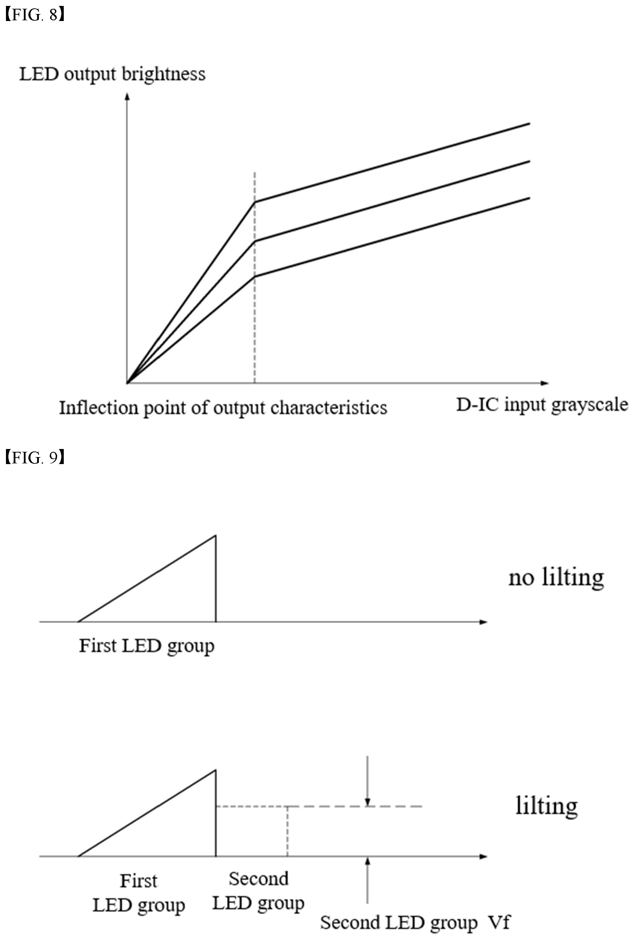

FIG. 6 illustrates a constant current waveform of a display device for signage according to internally developed prior technology, FIG. 7 illustrates a frame-by-frame PWM of a display device for signage according to internally developed technology, and FIG. 8 is a graph showing side effects when an offset is applied to a display device for signage according to internally developed technology.

In the display device for signage according to internally developed technology, unlike an ideal constant current waveform, an actual waveform is formed with a slope.

In internally developed technology, since an actual waveform has a slope, when an LED lighting time becomes short in a low grayscale, a problem occurs in that a forward voltage of an LED package (A) cannot be formed and thus the LED is not lit.

In order to solve such a problem, in internally developed technology, there has been an effort to add an offset or combine PWM in a subframe unit so as to reach a forward voltage of the LED package (A).

Referring to FIG. 6, in internally developed technology, the LED package (A) adds an offset of a predetermined length when one subframe operates so as to reach a forward voltage (Vf) of the LED package (A).

However, when the offset is added, since a width increases for each PWM of each subframe, side effects may occur such that an initial light amount increases and an inflection point is generated as shown in FIG. 7.

Referring to FIG. 7, in internally developed technology, PWM in a subframe unit of the LED package (A) is combined so as to reach a forward voltage of the LED package (A).

However, since PWM of another subframe is combined, there is a problem in that no light is emitted in a subframe section without PWM, thereby causing a flicker phenomenon.

Referring to FIG. 8, when an offset is applied to a display device for signage according to internally developed technology, that is, when a function of adding PWM (offset) of a predetermined length each time one subframe operates is applied, there is a problem in that a variation amount of output brightness characteristics increases before and after an inflection point of output characteristics.

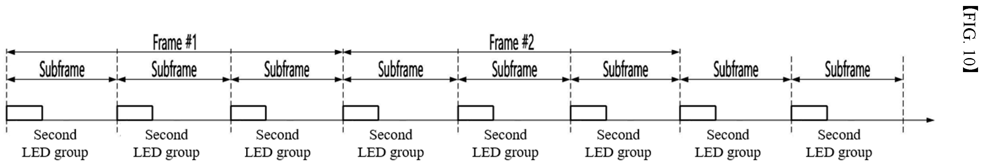

FIG. 9 illustrates a waveform of a display device for signage (1000) according to an embodiment of the present invention, and FIG. 10 illustrates a PWM graph of a display device for signage (1000) according to an embodiment of the present invention.

The display device for signage (1000) according to the embodiment may include a first LED group (100) and a second LED group (200).

The second LED group (200) may function as an offset of the first LED group (100). That is, the LED package may be turned on by the second LED group (200).

Since the second LED group (200) has a forward voltage lower than a forward voltage of the first LED group

(100), unlike a conventional offset, an influence on image quality may be small.

Further, since the first LED group (100) and the second LED group (200) have different forward voltages (Vf), that is, different amplitudes, lighting in a low grayscale is possible using only the second LED group (200).

Accordingly, a color lumping phenomenon in a low grayscale and a non-lighting phenomenon in a certain section of a low grayscale can be prevented.

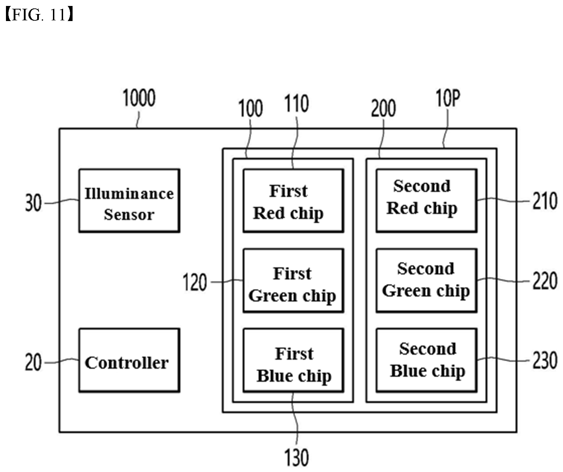

FIG. 11 is a diagram illustrating a configuration of a display device for signage according to an embodiment of the present invention.

The display device for signage (1000) according to an embodiment may include the LED package (10P), a controller (20) for controlling the LED package, and an illuminance sensor (30) for sensing external light.

The LED package (10P) may include a first LED group (100) and a second LED group (200). However, this is only an example, and a plurality of various LED groups may be included.

The first LED group (100) may include a first Red chip (110), a first Green chip (120), and a first Blue chip (130). The second LED group (200) may include a second Red chip (210), a second Green chip (220), and a second Blue chip (230).

A White chip may be further included in the LED chips included in the first LED group (100) and the second LED group (200).

The controller (20) may control a mode of the display (1) according to an amount of light recognized by the illuminance sensor (30).

A mode of the display device for signage (1000) may include a daytime mode, an HDR mode, and a night mode.

The controller (20) may control the display device for signage (1000) in the daytime mode when it is recognized that an external environment is daytime according to an amount of light recognized by the illuminance sensor (30).

In the daytime mode of the display device for signage (1000), the LED package (10P) may drive only the first LED group (100), and may not drive the second LED group (200).

The controller (20) may control the LED package (10P) in the HDR mode when an external environment is a time or a season in which sunlight is strong according to an amount of light recognized by the illuminance sensor (30).

In the HDR mode of the display device for signage (1000), the LED package (10P) may drive both the first LED group (100) and the second LED group (200).

The controller (20) may control the display device for signage (1000) in the night mode when it is recognized that an external environment is night according to an amount of light recognized by the illuminance sensor (30).

In the night mode of the display device for signage (1000), the LED package (10P) may drive only the second LED group (200), and may not drive the first LED group (100).

Since a current range of the second LED group (200) is formed to be small, a low grayscale having high color depth can be expressed even at a low luminance of 300 nit or less.

Since the current range of the second LED group (200) is formed to be smaller than a current range of the first LED group (100), an effect of energy reduction can be obtained in the night mode.

Further, since LED groups driven according to each mode are different, a current applied to the LED package may be formed differently in each mode.

Accordingly, in the night mode, a non-lighting phenomenon, a color lumping phenomenon, and a flicker phenomenon in a low grayscale can be prevented.

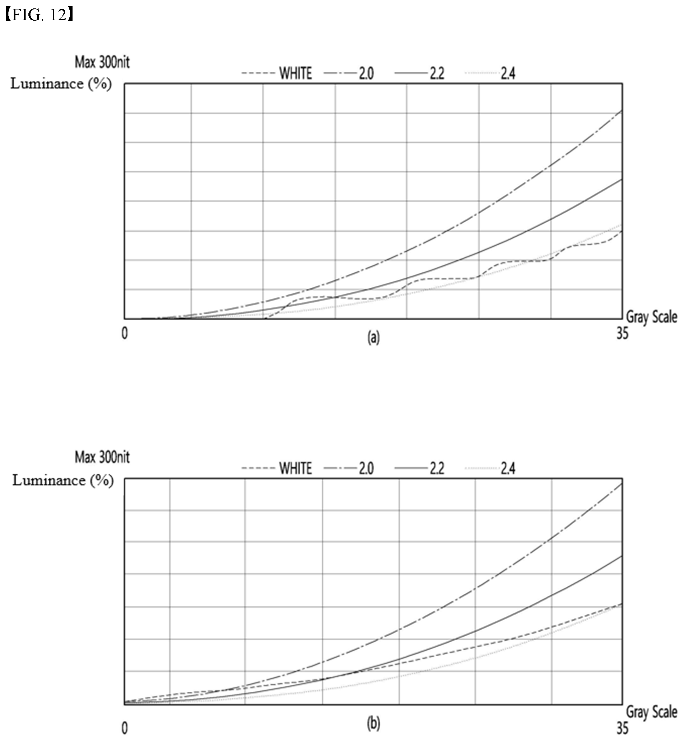

FIG. 12 is a graph showing a gamma curve of a display device for signage according to internally developed technology and a gamma curve according to an embodiment of the present invention.

FIG. 12(a) is a graph showing a gamma curve in a night mode of a display device for signage according to internally developed technology, and FIG. 12(b) is a graph showing a gamma curve in a night mode of a display device for signage according to an embodiment of the present invention.

In the display device for signage according to internally developed technology, it can be seen that a gamma curve of a White value has a stepped and uneven form. Due to such a phenomenon, a non-lighting phenomenon and a color lumping phenomenon in a low grayscale may occur.

On the other hand, in the display device for signage according to an embodiment of the present invention, a gamma curve of a White value has a smooth curve form.

In the case of the display device for signage according to the embodiment, since all of a 14-bit color depth can be expressed, expressive power in a low grayscale may be rich even in a night mode of low luminance.

Accordingly, a color lumping phenomenon or a non-lighting phenomenon in a low grayscale can be prevented, and uniformity of pixels can be improved.

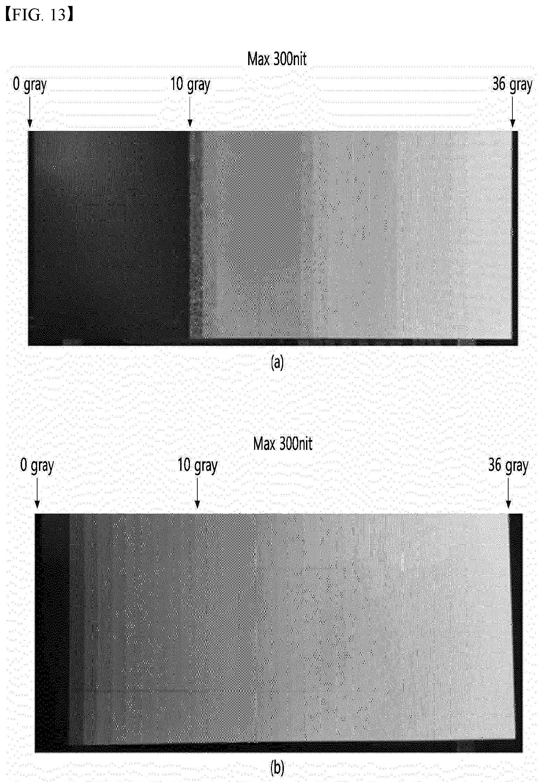

FIG. 13 is a photograph comparing expressive power of a display device for signage according to internally developed technology and a display device for signage according to an embodiment of the present invention.

FIGS. 13(a) and 13(b) are photographs showing grayscale levels in a night mode having a luminance of 300 nit in a display device for signage according to internally developed technology and a display device for signage according to an embodiment of the present invention.

As shown in FIG. 13(a), in the display device for signage according to internally developed technology, a non-lighting section of 0 to 10 gray occurs, a color lumping phenomenon occurs in some sections, and there is a problem in that pixels emit light non-uniformly.

FIG. 13(b) shows a display device for signage according to an embodiment of the present invention, and since it has an expressive power of 14 bit, a non-lighting phenomenon in a low grayscale section does not occur, and a color lumping and a non-uniform problem of pixels do not occur.

Although the embodiments have been described above, these are merely examples and do not limit the embodiments, and those skilled in the art to which the embodiments pertain will understand that various modifications and applications not exemplified above are possible without departing from the essential characteristics of the embodiments. For example, each component specifically shown in the embodiment may be modified and implemented. Differences related to such modifications and applications should be interpreted as being included in the scope of the embodiments defined in the appended claims.

### Description of Reference Numerals

| | | | |
|---|---|---|---|
| 1000: | display device for signage | 10: | LED package |
| 20: | controller | 30: | illuminance sensor |
| 100: | first LED group | 200: | second LED group |

### Industrial Applicability

The display device (1000) of the embodiment can be applied to Digital Signage. For example, although the display device (1000) of the embodiment is an example of indoor digital signage, the display device (1000) of the embodiment can also be applied to outdoor digital signage.

## Claims

1. A display device for signage, comprising:
an LED package having a plurality of LED groups;
an illuminance sensor for detecting illuminance of external light; and
a controller for controlling the LED package according to the illuminance sensor;
wherein the plurality of LED groups have different forward voltages from each other, and
wherein the controller drives the LED package in different modes according to the illuminance sensor.

2. The display device for signage of claim 1, wherein the LED package comprises:
a first LED group including a first Red chip, a first Green chip, and a first Blue chip; and
a second LED group including a second Red chip, a second Green chip, and a second Blue chip,
wherein a forward voltage of the second LED group is smaller than a forward voltage of the first LED group.

3. The display device for signage of claim 2, wherein the controller is configured to drive the LED package in a daytime mode when it is determined that an external environment is daytime by the illuminance sensor, and
wherein in the daytime mode, the LED package is configured to drive the first LED group and does not drive the second LED group.

4. The display device for signage of claim 2, wherein the controller is configured to drive the LED package in an HDR mode when it is determined that an external environment requires high luminance light by the illuminance sensor, and
wherein in the HDR mode, the LED package is configured to drive both the first LED group and the second LED group.

5. The display device for signage of claim 2, wherein the controller is configured to drive the LED package in a night mode when it is determined that an external environment is night by the illuminance sensor, and
wherein in the night mode, the LED package does not drive the first LED group and drives only the second LED group.

6. A method of driving a display device for signage of claim 1, wherein the controller is configured to control the LED package in a daytime mode, an HDR mode, and a night mode according to the illuminance sensor, and
an amount of current applied to the LED package is different depending on the mode.

7. The method of claim 6, when the controller is configured to drive the LED package in the night mode, a current applied to the LED package is smaller than a current applied to the LED package in the daytime mode and the HDR mode.
